Europäisches Patentamt

European Patent Office

Office européen des brevets

(19)

(11) Numéro de publication : **0 490 761 A1**

# (12) DEMANDE DE BREVET EUROPEEN

(21) Numéro de dépôt : **91403347.7**

(22) Date de dépôt : **10.12.91**

(51) Int. Cl.⁵ : **H01L 23/485,** H01L 21/285, H01L 21/321

(30) Priorité : **13.12.90 FR 9015615**

(43) Date de publication de la demande :
**17.06.92 Bulletin 92/25**

(84) Etats contractants désignés :
**DE FR GB**

(71) Demandeur : **FRANCE TELECOM**
**6 place d'Alleray**
**F-75015 Paris (FR)**

(72) Inventeur : **Vuillermoz, Bernard**
**22 Boulevard Maréchal Leclerc**
**F-38000 Grenoble (FR)**
Inventeur : **Bakli, Mouloud**
**1 Allée de la Faculté**
**F-38240 Meylan (FR)**
Inventeur : **Straboni, Alain**
**13 Rue Stendhal**
**F-38320 Eybens (FR)**

(74) Mandataire : **Fréchède, Michel**
**Cabinet Plasseraud 84, rue d'Amsterdam**
**F-75009 Paris (FR)**

(54) **Procédé de réalisation d'une barrière de diffusion électriquement conductrice à l'interface métal/silicium d'un transistorMOS et transistor correspondant.**

(57) L'invention concerne un procédé de réalisation d'une barrière de diffusion électriquement conductrice à l'interface métal/silicium d'un circuit intégré.

Suite à un dépôt sélectif de métal a), b) formant interface métal/silicium, le procédé consiste à soumettre c) l'interface à un plasma à base d'azote pendant une durée d'au moins cinq minutes et à porter l'interface à une température supérieure à 500°C pendant cette durée pour créer une couche de nitrure de silicium formant barrière de diffusion. L'interface d) est ensuite soumise à un traitement de recuit en atmosphère neutre afin d'éliminer l'azote introduit dans le métal précédemment.

Application à la réalisation des circuits intégrés de type transistor MOS.

FIG.1.

Dans le domaine technique de la fabrication des circuits intégrés, notamment des transistors MOS, il est de plus en plus nécessaire de stabiliser les propriétés physico-chimiques des différentes zones de ces circuits intégrés, notamment au niveau des interfaces de contact métal/matériau semi-conducteur.

Parmi les récents développements de ce domaine technique, on a proposé d'utiliser comme métal de contact, destiné à assurer les contacts électriques avec les zones de source, de grille et de drain de ces transistors, un métal tel que le tungstène. L'apport du métal correspondant sur les zones de grille, de source ou de drain est effectué, habituellement, par une métallisation par dépôt sélectif de tungstène par dépôt chimique en phase vapeur.

Une telle technique présente de nombreux avantages, le dépôt sélectif précité étant facile à réaliser, moyennant les précautions habituelles de mise en oeuvre, au moyen de machines appropriées, telles que les machines industrielles commercialisées en France par les sociétés SPECTRUM et TEGAL.

En outre, le dépôt en phase vapeur précité ne produit aucune consommation incontrôlée de silicium lors de la mise en oeuvre de celui-ci.

Le tungstène lui-même présente une excellente valeur de résistivité, de l'ordre de 8 $\mu\Omega$.cm, ce qui justifie le choix de ce dernier afin de réaliser les connexions électriques des différentes zones du transistor ou circuit intégré correspondant.

Ce matériau présente également une bonne qualité de conformité du recouvrement des zones précitées, ce qui se traduit par une bonne homogénéité mécanique et électrique des contacts électriques correspondants.

Toutefois si l'interface métal/silicium constitue une bonne barrière de diffusion, lorsque le métal de dépôt choisi est le tungstène, entre les molécules de tungstène et de silicium, il n'en va cependant pas de même lorsque ce métal choisi est soumis à des températures importantes, ce qui réduit sensiblement l'intérêt d'un tel choix.

L'inconvénient majeur du choix du tungstène apparaît être la réactivité de ce métal avec le silicium pour former un siliciure de tungstène WSi2 à une température supérieure à 700°C. Ceci a pour conséquence d'augmenter la résistivité et la résistance du contact de connexion et de consommer du silicium des jonctions des zones correspondantes en créant une interface WSi2/Si rugueuse. On notera en particulier que des études récentes, confer Vacuum Technology Industrial Research & Development - March 1983 p 141-147, ayant fait état d'une certaine stabilité de la structure A1/W/Si, celle-ci est cependant limitée à une température de l'ordre de 500°C.

Une telle stabilité peut être suffisante pour un circuit intégré simple métal, c'est à dire à un seul niveau d'interconnexion, mais ne peut convenir pour les circuits intégrés modernes à double métal, où l'interface W/Si est à 950°C, notamment lors de l'étape de fluage du diélectrique intermétallique.

La présente invention a pour but de remédier aux inconvénients précités par la mise en oeuvre d'un procédé de réalisation d'une barrière de diffusion électriquement conductrice à l'interface métal/silicium d'un transistor MOS.

Un autre objet de la présente invention est la mise en oeuvre de ce procédé plus particulièrement dans le cas où le métal utilisé est le tungstène.

Un autre objet de la présente invention est enfin la mise en oeuvre d'un transistor de type MOS comportant au niveau de l'interface métal/silicium des contacts des zones de source de drain et de grille une barrière de diffusion électriquement conductrice.

Le procédé de réalisation d'une barrière de diffusion électriquement conductrice à l'interface métal/silicium d'un circuit intégré, objet de l'invention, est remarquable en ce que suite à un dépôt sélectif de métal destiné à constituer l'interface, celui-ci consiste à soumettre cette interface à un plasma à base d'azote pendant une durée d'au moins cinq minutes et à porter l'interface à une températaure supérieure à 500°C pendant cette durée de façon à créer, au niveau de l'interface, une couche de nitrure de silicium formant la barrière de diffusion. L'ensemble constitué par l'interface et par la barrière de diffusion est soumis à un traitement de recuit, en atmosphère neutre, afin d'éliminer l'azote introduit dans le métal au cours de l'étape précédente.

Le transistor MOS de type circuit intégré comportant sur un substrat de silicium de type N ou P une zone de source, une zone de grille et une zone de drain de type opposé P ou N, chacune des zones comportant à sa surface libre une couche de métal, formant ledit transistor MOS et ses contacts, est remarquable en ce que ce transistor comporte au niveau des zones de source, de grille respectivement de drain une barrière de diffusion électriquement conductrice en nitrure de silicium, ladite barrière de diffusion formant une interface de liaison et de protection entre chaque zone de source, de drain ou de grille et la couche de métal correspondante recouvrant celle-ci.

Le procédé objet de l'invention et le transistor correspondant trouvent application dans le domaine de l'industrie des circuits intégrés.

Une description plus détaillée du procédé et du transistor de type MOS objets de l'invention sera donnée à la lecture de la description et à l'observation des dessins dans lesquels :

   - la figure 1, en ses points a), b), c) et d), représente les étapes essentielles de la mise en oeuvre du pocédé objet de l'invention,
   - la figure 2 représente une vue, en coupe, d'un transistor MOS double métal conforme à l'objet de la présente invention.

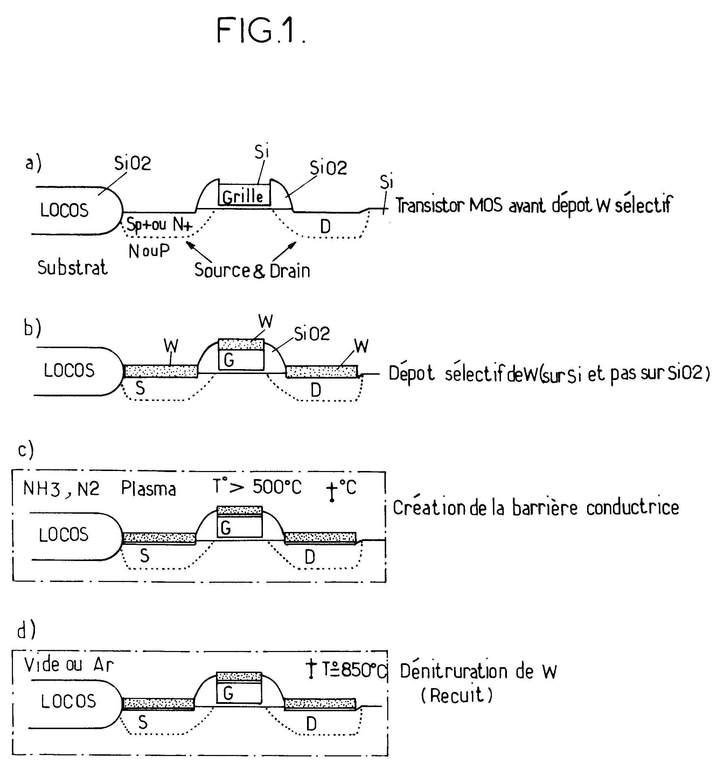

Une description plus détaillée d'un mode de mise en oeuvre du procédé de réalisation d'une barrière de diffusion électriquement conductrice à l'interface métal/ silicium d'un transistor MOS objet de la présente invention sera maintenant donnée en liaison avec la figure 1.

Sur la figure 1 précitée, en particulier au point a) de celle-ci, on a représenté, en coupe, une vue d'un transistor MOS et des régions constituant celui-ci. On reconnaît en paticulier, pour le circuit intégré constituant le transistor MOS précité dans un substrat de silicium de type N ou P, l'existence d'une zone de source S, d'une zone de grille G, cette grille étant de type grille isolée par l'intermédiaire d'une isolation de type SiO2 et d'une zone de drain D. On notera que les zones de source et de drain sont de type de semiconducteurs opposé au type de substrat, ces zones étant de type P ou N dopées respectivement. Sur le point a) de la figure 1 on a, en fait, représenté la vue en coupe précitée préalablement au dépôt sélectif du métal destiné à réaliser sur les zones du transistor MOS précité les contacts correspondantes.

De manière générale non limitative, on considèrera que le métal choisi pour effectuer le dépôt est du tungstène, W.

Au point b) de la même figure 1, on a représenté le même transistor MOS suite au dépôt sélectif de métal, c'est à dire de tungstène, ce dépôt sélectif intervenant bien entendu sur les zones correspondantes précédemment mentionnées, c'est à dire sur les zones de silicium, et non pas sur les zones d'isolation SiO2. Les dépôts métalliques précités constituent alors les contacts des zones de source S, de grille G et de drain D.

Ainsi, chaque dépôt métallique sur la zone correspondante source, grille ou drain constitue une interface de type métal/silicium.

Conformément au procédé objet de l'invention, ainsi que représenté notamment en figure 1, au point c), celui-ci consiste alors à soumettre l'interface précitée à un plasma à base d'azote pendant une durée d'au moins cinq minutes et à porter l'interface précédemment mentionnée à une température supérieure à 500°C pendant cette durée. Un tel mode opératoire permet de créer au niveau de l'interface précitée une couche de nitrure de silicium formant la barrière de diffusion conductrice recherchée.

A titre d'exemple non limitatif, on a représenté, sur la figure 1 au point c) de celle-ci, le circuit intégré précédemment représenté au point b) placé dans un four à plasma l'ensemble du substrat et des interfaces métal/silicium à traiter étant maintenu par des moyens de chauffage non représentés à une température supérieure à 500°C.
Bien entendu, le plasma est créé de manière classique, ce plasma étant constitué essentiellement à base d'azote.

On notera bien entendu que le plasma précité peut être constitué par un plasma d'azote pur, N2, mais que ce plasma peut également être constitué par un plasma d'ammoniac, NH3.

Les plasmas précédemment mentionnés peuvent être réalisés dans les fours à plasma normalement disponibles dans le commerce et les conditions opératoires de tels fours à plasma ne seront pas décrites pour cette raison.

On notera simplement que dans le cas de la mise en oeuvre d'un plasma d'azote pur, N2, l'interface métal/silicium du transistor MOS considéré à traiter est soumis à un plasma d'azote tel que précédemment mentionné pendant une durée de dix minutes par exemple. L'interface est alors en outre portée pendant cette durée à une température de 700°C par exemple, pour engendrer une couche de nitrure de silicium formant la barrière de diffusion d'une épaisseur de préférence égale à 2 nm.

Suite à l'étape représentée au point c) de la figure 1, le procédé de l'invention consiste alors à soumettre l'ensemble constitué par l'interface et par la barrière de diffusion au niveau de chacune des zones du transistor MOS considéré à un traitement de recuit en atmosphère neutre, afin d'éliminer l'azote introduit dans le métal au cours de l'étape c) précédente.

On comprendra bien sûr qu'en raison du fait que le traitement de recuit est essentiellement destiné à effectuer une dénitruration du métal déposé sur chacune des zones du transistor MOS considéré, en particulier du tungstène lorsque ce métal a été choisi, l'atmosphère neutre peut être constituée par toute atmosphère gazeuse non oxydante à l'exclusion de l'azote. On pourra alors placer le circuit intégré considéré, ainsi que représenté au point d) de la figure 1 dans une enceinte étanche, une étuve étanche par exemple dans laquelle une atmosphère d'argon, par exemple, aura été introduite sous faible pression. En outre, et de manière non limitative, l'atmosphère neutre pourra être simplement réalisée par le vide. On notera en particulier que cette dernière solution apparaît avantageuse dans la mesure où la dénitruration peut ainsi être réalisée dans des conditions tout à fait satisfaisantes, les gaz de dénitruration étant ainsi absorbés par le système de mise sous vide de l'enceinte étanche, lequel n'est pas représenté sur la figure 1.

Dans le cas du point d) de la figure 1, la température de recuit peut être choisie égale par exemple à 850°C.

On notera que le procédé objet de l'invention tel que décrit précédemment en relation avec la figure 1 permet ainsi d'assurer la création d'une couche de nitrure de silicium SI3N4 de l'ordre de deux nanomètres, cette couche empêchant la diffusion du silicium dans le métal et en particulier dans le tungstène, W, ce qui a pour effet d'empêcher la formation de siliciure de tungstène ou de siliciure de métal. En outre, la couche formant barière de diffusion, couche de nitrure de silicium SI3N4, est suffisamment mince pour être électriquement conductrice sans augmenter de manière rédhibitoire la résistivité et la résistance totale de l'interface métal/silicium. On notera, en effet, que le traitement de recuit sous vide par exemple à 850°C, ainsi qu'il était précédemment décrit, permet ensuite d'éliminer l'azote introduit dans le métal, le tungstène, ce qui permet alors à ce dernier de retrouver sa résistivité initiale.

On notera que le procédé objet de la présente invention est particulièrement avantageux dans la mesure où celui-ci n'utilise pas de masque supplémentaire.

On notera que le procédé objet de la présente invention peut être mis en oeuvre au moyen de la machine industrielle désignée par la dénomination URANOS, une telle machine permettant de réaliser et de mettre en oeuvre le procédé objet de l'invention de façon particulièrement adaptée. Pour une description plus complète d'une telle machine, on pourra se reporter à la demande de brevet européen n° EP 84 402 319.

On notera enfin que le mode de réalisation tel que précédemment décrit en liaison avec la figure 1 du procédé objet de l'invention correspond à des conditions expérimentales établies pour le traitement d'une interface métal/silicium pour laquelle l'épaisseur de métal déposé, tel que le tungstène correspond à une épaisseur de l'ordre de 100 nm.

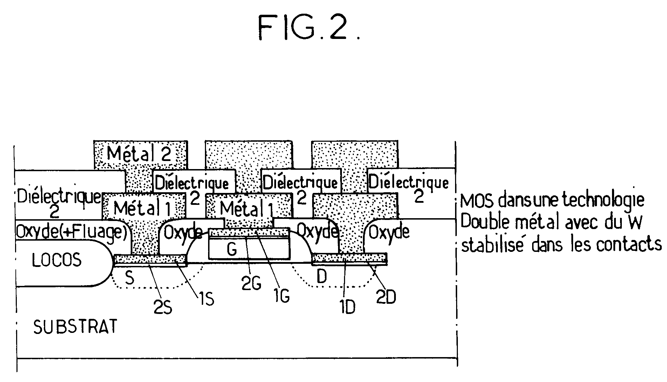

Une description plus détaillée d'un transistor MOS de type circuit intégré conforme à l'objet de la présente invention sera donnée en liaison avec la figure 2.

Selon la figure précitée, celle-ci représentant un tel transistor MOS selon une vue en coupe dans le plan d'alignement des zones de source, de grille et de drain, comporte sur un substrat de silicium de type N ou P, une zone de source S, une zone de grille G, isolée par l'intermédiaire d'un support en oxyde de silicium SiO2, et une zone de drain D, les zones de source S et de drain D étant de type de semi-conducteur opposé, de type P ou N, à celui du substrat. Chaque zone comporte à sa surface libre une couche de métal notée 1S, 1G, 1D, correspondant chacune respectivement à la zone de source, de grille, de drain, l'ensemble constituant le transistor MOS et ses connexions. Le terme LOCOS désigne une zone en oxyde de silicium SiO$_2$.

Ainsi qu'on l'a représenté en outre en figure 2, le transistor objet de l'invention comporte au niveau des zones de source S, de grille G et de drain D, une barrière de diffusion électriquement conductrice notée respectivement pour chacune des zones 2S, 2G et 2D. Chaque barrière de diffusion électriquement conductrice est en nitrure de silicium et forme ainsi une interface de liaison et de protection entre chaque zone de source S, de drain D ou de grille G et la couche de métal correspondante 1S, 1D, 1G, recouvrant celle-ci.

De préférence, et de manière non limitative, la barrière de diffusion électriquement conductrice 2S, 2D, 2G, présente une épaisseur de l'ordre de deux namomètres.

On notera que de manière avantageuse non limitative, le métal assurant les contacts et constituant interface métal/silicium peut alors être choisi avantageusement comme constitué par du tungstène, ce qui, bien entendu, permet d'utiliser les propriétés remarquables de ce métal précédemment mentionnées dans la description pour réaliser les zones de contact.

On notera bien sûr que dans le cas de la figure 2, le transistor MOS représenté est un transistor double métal, c'est à dire un transistor comportant deux niveaux de métallisation pour réaliser les contacts, ces deux niveaux de métallisation étant désignés respectivement métal 1, métal 2, sur la figure 2 et se superposant ainsi aux interfaces de connexion notées respectivement 1S, 2S, 1G, 2G, 1D, 2D. Bien entendu, et de manière classique, l'oxyde de silicium destiné à isoler les parties ou niveaux métalliques métal 1, métal 2 des deux niveaux de métallisation est apporté de manière classique par fluage. Le procédé objet de l'invention permet ainsi de réaliser des circuits intégrés double métal avec connexion en tungstène dans lesquels l'interface tungstène/silicium est soumise à des températures de l'ordre de 750°C à 950°C en particulier lors de l'étape de fluage du diélectrique intermétallique ou de l'oxyde de silicium correspondant sans pour cela provoquer la migration W/Si pour former le siliciure de tungstène au-delà d'une température de 700°C.

On notera enfin que le procédé objet de la présente invention est particulièrement intéressant dans la mesure où, en outre, celui-ci se distingue d'autres procédés de l'art antérieur dans lesquels afin de palier à l'inconvénient précité, il a été proposé de déposer une couche intermédiaire de nitrure de titane, un tel procédé, notamment, apparaissant d'une mise en oeuvre peu adaptée dans la mesure où ce procédé nécessite l'utilisation d'un masque supplémentaire.

## Revendications

1. Procédé de réalisation d'une barrière de diffusion électriquement conductrice à l'interface métal/silicium d'un circuit intégré dans lequel, suite à un dépôt sélectif (b) de métal destiné à constituer ladite interface, ledit procédé consiste :

   – à soumettre (c) ladite interface à un plasma à base d'azote pendant une durée d'au moins cinq minutes et à porter ladite interface à une température supérieure à 500°C pendant cette durée, de façon à créer, au niveau de ladite interface, une couche de nitrure de silicium formant ladite barrière de diffusion,

– à soumettre (d) l'ensemble constitué par ladite interface et par la barrière de diffusion à un traitement de recuit, en atmosphère neutre, afin d'éliminer l'azote introduit dans le métal au cours de l'étape précédente.

2. Procédé selon la revendication 1, caractérisé en ce que le plasma à base d'azote est un plasma d'azote pur.

3. Procédé selon la revendication 1, caractérisé en ce que le plasma à base d'azote est un plasma d'ammoniac, NH3.

4. Procédé selon la revendication 1 ou 2, caractérisé en ce que ladite interface est soumise à un plasma d'azote pendant une durée de dix minutes, ladite interface étant en outre portée, pendant cette durée, à une température de 700°C pour engendrer une couche de nitrure de silicium formant ladite barrière de diffusion d'épaisseur 2nm.

5. Procédé selon l'une des revendications précédentes, caractérisé en ce que ledit traitement (d) de recuit est effectué sous vide, ledit ensemble étant porté à une température de l'ordre de 850°C.

6. Transistor MOS de type circuit intégré comportant sur un substrat de silicium de type N ou P une zone de source (S), une zone de grille (G), isolée et une zone de drain (D) de type opposé P ou N, chacune desdites zones comportant à sa surface libre une couche de métal (1S, 1G, 1D), formant ledit transistor MOS et ses contacts, caractérisé, en ce que le dit transistor comporte au niveau desdites zones de source (S), de grille (G) respectivement de drain (D) une barrière de diffusion électriquement conductrice (2S, 2G, 2D) en nitrure de silicium, ladite barrière de diffusion électriquement conductrice formant une interface de liaison et de protection entre chaque zone de source (S), de drain (D) ou de grille (G) et la couche de métal correspondante (1S, 1G, 1D) recouvrant celle-ci.

7. Transistor MOS selon la revendication 6, caractérisé en ce que ladite barrière de diffusion électriquement conductrice (2S, 2D, 2G) présente une épaisseur de 2nm.

8. Transistor MOS selon l'une des revendications 6 ou 7, caractérisé en ce que le métal est du tungstène.

# FIG.1.

a)

Transistor MOS avant dépôt W sélectif

SiO2 — Si — SiO2 — Si
LOCOS — Grille
Sp+ou N+ — D
N ou P
Source & Drain
Substrat

b)

Dépôt sélectif de W (sur Si et pas sur SiO2)

W — W — SiO2 — W
LOCOS — G
S — D

c)

Création de la barrière conductrice

NH3 , N2   Plasma     T° > 500°C    ↑°C
LOCOS — G
S — D

d)

Dénitruration de W
(Recuit)

Vide ou Ar           ↑ T≅850°C
LOCOS — G
S — D

# FIG.2.

Métal 2

Diélectrique 2   Diélectrique 2   Diélectrique 2

Diélectrique 2   Métal 1   2   Métal 1   2   2

Oxyde(+Fluage)   Oxyde   Oxyde   Oxyde

LOCOS   G

S   2G   1G   D

2S   1S   1D   2D

SUBSTRAT

MOS dans une technologie
Double métal avec du W
stabilisé dans les contacts

Office européen
des brevets

**RAPPORT DE RECHERCHE EUROPEENNE**

Numero de la demande

EP    91 40 3347

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | EXTENDED ABSTRACTS. vol. 86, no. 2, 19 Octobre 1986, PRINCETON, NEW JERSEY US page 479; J. AMOUROUX ET.AL.: 'Silicon and Titanium Nitriding by an H.F. NH3 Low Pressure Plasma' * le document en entier * | 1,6 | H01L23/485 H01L21/285 H01L21/321 |
| A | US-A-4 847 111 (CHOW ET.AL.) * abrégé * | 1,6 | |

**DOMAINES TECHNIQUES RECHERCHES (Int. Cl.5 )**

H01L

Le présent rapport a été établi pour toutes les revendications

| Lieu de la recherche | Date d'achèvement de la recherche | Examinateur |
|---|---|---|
| LA HAYE | 16 MARS 1992 | N.J. PHEASANT |

EPO FORM 1503 03.82 (P0402)

8